# EUROPEAN PATENT APPLICATION

(11) **EP 4 610 665 A1**
(43) Date of publication of application: **03.09.2025**
(21) Application number: 24160677.1
(22) Date of filing: 29.02.2024
(51) Int. Cl.: G01R 1/04, G01R 31/27, G01R 31/28

(54) **PROBE HEAD AND PROBE CARD FOR TESTING HIGH VOLTAGE SEMICONDUCTOR COMPONENTS AND METHOD USING THE SAME**

(71) Applicant: Cohu GmbH, 83059 Kolbermoor (DE)
(72) Inventor: Engelbrecht, Stefan, 83052 Bruckmühl (DE); Mederer, Christoph, 83075 Bad Feilnbach (DE); Westenhuber, Mathias, 83122 Samerberg (DE); Wagner, Markus, 83059 Kolbermoor (DE)
(74) Representative: Dilg, Haeusler, Schindelmann Patentanwaltsgesellschaft mbH

(57) **Abstract**

A probe head for parallel testing a plurality of electronic components on a wafer, in particular for parallel testing high voltage semiconductor components, comprises: - an arrangement of a plurality of test sites wherein each test site is adapted to test a different electronic component, - a plurality of groups of contact elements, wherein each group of contact elements is assigned to a different one of the test sites and is adapted to contact to the respective electronic component, and wherein the probe head further comprises:- a plurality of gas supply channels wherein each gas supply channel passes through a different test site of the plurality of test sites and supplies separately pressurized gas to the assigned group of contact elements. A probe card and a method of using the probe head are provided.

## Description

### TECHNICHAL FIELD

Prober are used to test semiconductor components to be tested (or DUTs), wherein the semiconductor components are still integrated on a wafer. The invention relates to a probe head, and a probe card of a prober and a method using the same.

### BACKGROUND

In general, testing of semiconductor components may be done when the semiconductor components are already separated or when the semiconductor components are still integrated on the wafer. Testing of semiconductor components when being separated may be more expensive, since one further step, namely packaging is required. It means, that for "failed" tested electronic components the step of packaging is useless for these electronic components. As a consequence, there is an ever-increasing demand to test the electronic components on a wafer. This also applies to high voltage components, sometimes also referred to as "high power components", and to parallel testing. High voltage components are often tested under pressurized gas or air, according to Paschen's Law, so that arcing may be avoided. However, since the electronic components are located on the circular wafer and the test equipment is usually rectangular and forms a pressurized chamber being rectangular, it is currently not possible to achieve a parallel test for the components being located at the edge of a wafer. According to state-of-the-art it is only possible to do double testing and/or leaving a part of the components untested when parallel testing high voltage components.

### SUMMARY

There may be a need for a prober test, in particular as a parallel test for high voltage electronic components being cost effective and reducing double testing of the electronic components and/or leaving a part of the electronic components untested.

In order to meet the need defined above, a probe head for parallel testing a plurality of electronic components on a wafer, and a method of parallel testing electronic components using the probe head are provided according to independent claims 1 and 13. Further embodiments are subject to claims 2 to 12 and 14 to 20.

According to an embodiment of the invention, a probe head for parallel testing a plurality of electronic components on a wafer, in particular for parallel testing high voltage semiconductor components, comprises:
- an arrangement of a plurality of test sites wherein each test site is adapted to test a different electronic component,
- a plurality of groups of contact elements, wherein each group of contact elements (of the plurality of group of contact elements) is assigned to a different one of the test sites and is adapted to contact to the respective electronic component, and wherein the probe head further comprises
- a plurality of gas supply channels wherein each gas supply channel passes through a different test site of the plurality of test sites and supplies separately pressurized gas to the assigned group of contact elements.

According to an embodiment of the invention, a method of parallel testing a plurality of electronic components on a wafer, in particular for parallel testing high voltage semiconductor components, comprises providing:
- an arrangement of a plurality of test sites wherein each test site is adapted to test a different electronic component,
- a plurality of groups of contact elements, wherein each group of contact elements (of the plurality of group of contact elements) is assigned to a different one of the test sites and is adapted to contact to the respective electronic component, and wherein the probe head further comprises
- a plurality of gas supply channels wherein each gas supply channel passes through a different test site of the plurality of test sites, wherein the method further comprises:
- parallel testing the plurality of electronic components by contacting the assigned group of contact elements to the plurality of electronic components on the wafer, and
- supplying separately pressurized gas to the assigned group of contact elements by the gas supply channels.

The expression "probe head" may denote a core component of a probe card. The probe head is a part of the probe card which includes probes, or contact elements for contacting to an electronic component, or so called "OUT", or a plurality of DUTs. In this sense, the probe head includes and defines the number of I/Os, that is, proportional the number of DUTs which may simultaneously be tested. The expression "test site" may denote a functional part of the probe head. One test site may comprise the number of I/Os which is sufficient to test one DUT. The expression "contact element" or "DUT" may denote the part of a test site for functionally forming one I/O. E.g., the contact element may be formed as a wire probe, so-called "cantilever contact spring", or as a so-called "pogo pin". The contact element enables to contact to one contact portion of the DUT and the contact element transmits electrical signals to a board which in turn transmits the electrical signals to a computer for further analysis. The expression "group of contact elements" may refer to the number of contact elements, or number of functional I/Os, respectively, required to test one DUT. The expression "gas supply channel" may denote a part of the test site, and in particular, may denote a path to guide gas or air inside the test site and towards the contact elements. The expression "pressurized gas" may denote a gas having a pressure value which reduces a risk of arcing from one contact to a neighbouring contact element, to a neighbouring test site, or to a neighbouring DUT, according to Paschen's Law. The expression "supplying separately pressurized gas to an assigned group of contact elements by the gas supply channels" may denote that gas having a pressure value for reducing arcing may be guided inside one test site to its assigned group of contact elements.

A gist of the invention is to provide a limitation of a pressure decay caused from a specific test site when the specific test site is not located above a wafer. As a basis for this, each of a plurality of test sites may comprise a specific flow resistance. This may be crucial to provide sufficiently pressurized gas for each of the test sites which are used to test DUTs on a wafer. For this reason, it is advantageous to shape the flow resistance of for each of the gas supply channels which may provide pressurized gas through individual gas supply channel. In other words: A test head includes a plurality of test sites. One test site comprises one (assigned) group of contact elements for contacting to one DUT or electronic component. One test site comprises (at least) one individual gas supply channel for supplying pressurized gas to the assigned group of contact elements. That is, for every DUT and for each group of contact elements there is (at least) one path or gas supply channel for providing the pressurized gas. Having an individual supply of providing pressurized gas inside (each) one of the test sites may be a basis for limiting pressure loss or pressure decay, when a test site is not positioned above the wafer or an electronic component. Limiting pressure loss may be achieved by adjusting a flow resistance inside or towards each of the plurality (of at least two) gas supply channels. Adjusting the flow resistance for a gas supply channel may be achieved upstream by not changeable initial design, by a design allowing for individually and manually adjusting a diameter of a narrow passage, or by adjusting an electronically controllable throttle valve.

According to an exemplary embodiment of the probe head, the supply of separately pressurized gas through the gas supply channels is adaptable by a mechanical adjustment of a flow resistance for the plurality of the gas supply channels.

A mechanical and manual adjustment of the flow resistance may include any design applied to an upstream path which allows for initially or later setting or limiting the flow resistance to a certain value.

According to an exemplary embodiment of the probe head, a flow resistance for multiple of the gas supply channels is individually adjustable for each of the multiple gas supply channels.

In a special embodiment, the flow resistance of multiple of the gas supply channels may be changed individually to adapt the flow resistance for each of this multiple gas supply channels. Initially setting the flow resistance to a specific value and mechanically and/ or manually adjusting or changing the flow resistance in a further action may be seen independently, and hence may applied simultaneously or separately. I.e. an initial design and a later adjustment do not exclude each other neither for the probe head nor for the test site.

According to an exemplary embodiment, the probe head further comprises a plurality of electronically controllable throttle valves, wherein each one of the electronically controllable throttle valves is assigned to a different one of the gas supply channels, and wherein a flow resistance through each of the gas supply channels is electronically controlled by using the respective electronically controlled throttle valve.

Using electronically controllable throttle valves may be a further measure to adjust the flow resistance. Again, there may be all different measures applied individually or separately for one or each of the plurality of test sites: Initial design, mechanical or manual adjustment, and electronically controlled throttle valves may be provided mutually or separately for an arbitrary subgroup of the gas supply channels.

According to an exemplary embodiment of the probe head, the flow resistance through each of the gas supply channels is increased as to switch off the flow completely by the assigned electronically controllable throttle valve.

An extreme measure to limit gas pressure decay is to completely close a gas supply channel when the respective test site is located beside the wafer. This may be advantageous for reducing noise which may be caused by escaping air from the specific test site being which is not located above the wafer. According to an exemplary embodiment, the probe head further comprises a gas supply, wherein the gas supply provides pressurized gas for each of the plurality of gas supply channels.

There may be one device and one supply line for feeding pressurized gas of a specific pressure value towards and into the probe head. Downstream of the gas supply the flow resistance for a gas supply channel may be set to a value so that a pressure decay caused by a test site which is not located above the wafer is limited.

According to an exemplary embodiment of the probe head, the separately pressurized gas is set to a pressure value preventing arcing between the contact elements within each group of contact elements, between two neighbouring test sites, or between neighbouring DUTs, according to Paschen's Law.

It may be crucial that, according to Paschen's Law a pressure value of the pressurized gas is sufficient to allow for testing the DUTs and avoiding harm by arcing which may take place between neighbouring contact elements within one group of contact elements, between two neighbouring test sites, or between neighbouring DUTs.

According to an exemplary embodiment of the probe head, arcing between a first number of contact elements, adapted to contact to the wafer, is prevented according to Paschen's Law, in that a required gas pressure according to Paschen's Law is fulfilled for the first number of contact elements, by in combination providing separately pressurized gas with a specific pressure value for each of the contact sites, and setting a specific value of the flow resistance through gas supply channels for a respective second number of contact elements being adapted to be free of contacting to the wafer. In particular, the first number of contact elements, or first set of contact elements does not overlap with the second number of contact element, or second set of contact elements, respectively. In particular, the first number of contact elements may comprise contact elements within one group of contact elements, contact elements of two neighbouring test sites, or contact elements contacting to different or neighbouring DUTs.

The first number of contact elements may refer to a first subset of the plurality of groups of contact elements. The first number of contact elements may contact to DUTs of the wafer and may be provided with pressurized gas according to Paschen's Law. The second number of contact elements may refer to a second subset of the plurality of groups of contact elements which are located beside the wafer. There may be a pressure decay for the first subset caused by the second subset. However, depending on the distance of the contact elements, the provided gas pressure, the number of the second number of contact elements or the second subset, respectively, the pressure applied to the first number of contact elements may be sufficiently high enough to fulfil Paschen's Law for the contacting first number of contact elements.

According to an exemplary embodiment of the probe head, the pressurized gas is pressurized air.

According to an exemplary embodiment of the probe head, the arrangement of the test sites provides a plurality of test gaps between the test sites in that the test sites are adapted to test every other or less than every other of the electronic components in one and/or the other direction of a main plane of the wafer.

There may be test gaps between the test sites in one or another direction, so that there are DUTs in between neighbouring test sites which are not tested. I.e., a grid of test sites may be less dense than a grid of DUTs. This may be advantageous in that there may be more space to integrate the gas supply channels into the test site or to integrate a gas distribution splitting the gas supply into the separate gas supply channels within the test head or upstream of the test head.

According to an exemplary embodiment, the probe head further comprises
- a bottom surface, wherein the bottom surface comprises a main portion and a plurality of elevated portions, wherein
- each one of the elevated portions surrounds a different one of the groups of contact elements, and wherein the elevated portions are raised relative to the main portion.

The expression "bottom surface" or "bottom surface of the probe head" may denote the surface facing towards the wafer and extending in the same main plane as the main plane of the wafer. The expression that "elevated portions are raised relative to the main portion" of the bottom surface may denote that the complete bottom surface comprises a smaller area, namely "the elevated portions" and a larger area, namely the "main surface". The elevated portions may be elevated or higher compared to the main surface. The area of the elevated portions may be flat, so that any part of the elevated portions may have the same distance towards a wafer and may have the same height relative to the main surface of the bottom surface of the probe card. In this sense, the bottom surface of the probe card may have two parallel flat surfaces wherein the area of the elevated portions may be seen as a heightened contour on the main portion. Each single elevated portion of the elevated portions may surround exactly one group of contact elements of exactly one test site. There may be a one-to-one relationship between the raised surfaces and the test site, or the contact elements, respectively. The elevated portions or raised surfaces allow the contact elements to be separated in relation to the pressure, which may be supplied by a gas supply towards the test sites. That is, the pressure inside each of the test sites and around the contact elements may be higher and may prevent sparkover which could otherwise damage the DUTs and/or the test equipment. In addition, it may be easier to regulate and balance the pressure within the elevated portions since, if e.g. the elevated portions are chosen in a ring-like form. The ring-like form may have a circular, a rectangular or a quadratic shape or outline. In this case, there is a defined flow resistance given, mostly dependent on the width of the ring-like elevated portions. However, any form or contour of the elevated portions may be suitable if the pressure around the contact elements is raised during a test of the DUTs. A distance from the elevated portions or from the bottom surface, if being completely flat, towards the wafer may be 20-200 µm. This distance towards the wafer may also be "micro gap".

According to an exemplary embodiment, a probe card comprises the probe head according to any of the previously mentioned embodiments, and further comprises: a board with a plurality of through holes, and a gas distribution unit, wherein the gas distribution unit separates the gas supply into different gas supply branches each entering a different one of the plurality of through holes and wherein each one of the plurality of through holes of the board being arranged between the gas distribution unit and the probe head feeds a different one of the gas supply channels with separately pressurized gas, respectively.

Note that, the throttle valves may be arranged inside the probe head or may be arranged inside the gas distribution unit.

According to an exemplary embodiment of the method, supplying of separately pressurized gas through the gas supply channels comprises:
- adapting a flow resistance for the plurality of the gas supply channels by a mechanical adjustment.

Note that adapting the flow resistance may be done by design before testing. In this case it is necessary that first the gas supply channels are designed ready to use, and that an adaption of the flow resistance happens automatically caused by turbulent flow through the gas supply channels. According to an exemplary embodiment, the method comprises:
- adjusting a flow resistance for multiple of the gas supply channels individually for each of the multiple gas supply channels.

Note that adapting the flow resistance may be done before testing, when done manually.

According to an exemplary embodiment of the method, providing a plurality of electronically controllable throttle valves, wherein each one of the electronically controllable throttle valves is assigned to a different one of the gas supply channels, the method further comprises:
- electronically controlling a flow resistance through each of the gas supply channels is by using the respective electronically controlled throttle valve. According to an exemplary embodiment, the method comprises:
- increasing a flow resistance through each of the gas supply channels as to switch off the flow completely by the assigned electronically controllable throttle valve.

According to an exemplary embodiment of the method, the method comprises providing a gas supply, and wherein the method further comprises:
- providing pressurized gas for each of the plurality of gas supply channels by the gas supply.

According to an exemplary embodiment, the method comprises:
- setting the separately pressurized gas to a pressure value to prevent arcing between the contact elements within each group of contact elements, between two neighbouring test sites, or between neighbouring DUTs, according to Paschen's Law.

According to an exemplary embodiment, the method comprises:
- preventing arcing between a first number of contact elements according to Paschen's Law, the first number of contact elements contacting to the wafer, by providing a required gas pressure according to Paschen's Law for the first number of contact elements, wherein in combination
- providing separately pressurized gas with a specific pressure value to the first number of contact elements, and
- setting a specific value of the flow resistance through gas supply channels for a respective second number of contact elements, wherein the second number of contact elements not contact to the wafer.

According to an exemplary embodiment, the method comprises:
- providing pressurized air as the pressurized gas.

According to an exemplary embodiment, the method comprises providing a plurality of test gaps between the test sites, wherein the method further comprises:
- testing every other or less than every other of the electronic components in one and/or the other direction of a main plane of the wafer.

According to an exemplary embodiment, the method comprises providing a probe card and further providing a board with a plurality of through holes, and a gas distribution unit, wherein the gas distribution unit separates the gas supply into different gas supply branches each entering a different one of the plurality of through holes, wherein each one of the plurality of through holes of the board is arranged between the gas distribution unit and the probe head, wherein the method further comprises:
- feeding a different one of the gas supply channels with separately pressurized gas by a respective through hole.

### BRIEF DESCRIPTION OF DRAWINGS

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.
Fig. 1A shows a probe card in perspective view from above, according to an embodiment of the present invention.
Fig. 1B shows a cross-sectional view of the probe card indicated with Fig. 1A.
Fig. 1C shows the probe card in a perspective view from below, according to an embodiment of the invention.
Fig. 2A shows a cross-sectional view of a detail of the probe card as indicated with Fig. 1B.
Fig. 2B shows a cross-sectional view of a detail of the probe card as indicated with Fig. 2A.
Fig. 3A shows a schematic illustration of pressurized gas distribution of the probe card while testing semiconductor components of a wafer, according to an embodiment of the invention.
Fig. 3B shows a schematic illustration of the probe card when testing semiconductor components of a wafer, when the probe card is partially located next to the wafer.
Fig. 4A shows the gas distribution unit according to an embodiment of the invention.
Fig. 4B shows a bar chart of a flow rate decay according to an embodiment of the invention.
Fig. 4C shows a bar chart of a pressure decay according to an embodiment of the invention.

### DESCRIPTION OF EMBODIMENTS

The illustrations in the drawings are schematic. It is noted that in different figures similar or identical elements are provided with the same reference signs.

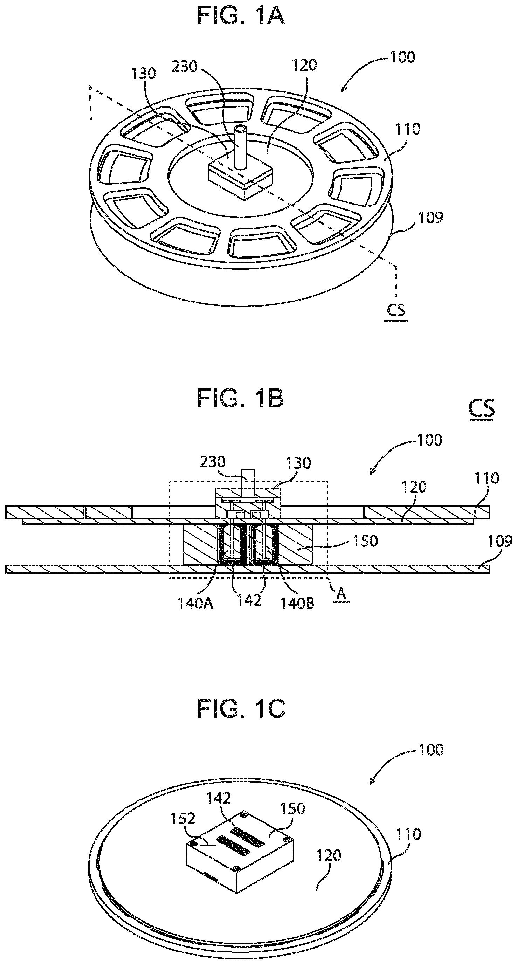

**Fig. 1A** shows a top view of a probe card 100. In this perspective view from above four parts of the probe card 100 are visible: The probe card comprises a stiffener 110 for supporting a board (PCB) 120. Central to the board 120 and the stiffener 110, the probe card 100 comprises a gas distribution unit 130 and on top of it a gas supply 230, for providing pressurized gas to the gas distribution unit 130. Below the probe card 100 and not part of the probe card 100 a wafer 109 is shown which may comprise electronic components to be tested (or so called DUTs = device under test) facing towards a bottom surface of the probe card 100.

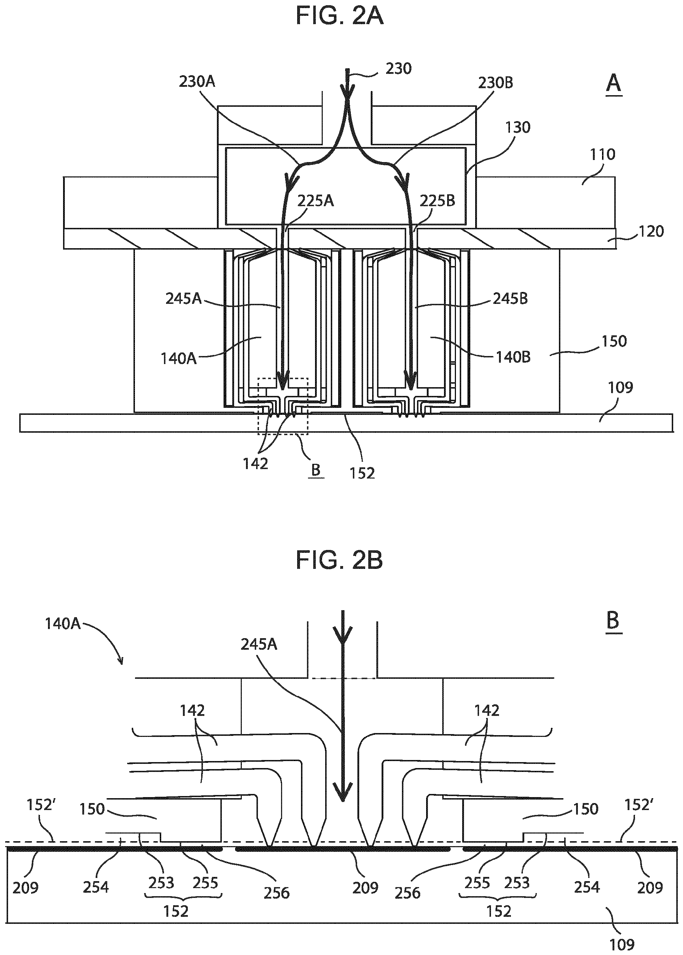

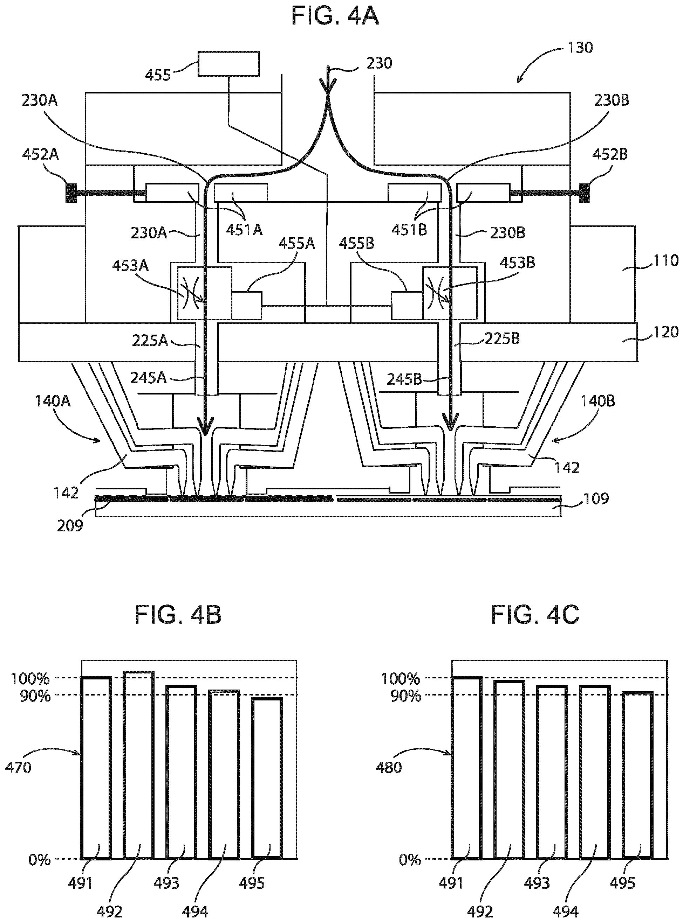

**Fig. 1B** shows a cross-sectional view of the probe card 100 indicated with Fig. 1A. In addition to Fig. 1A, the cross section (CS as indicated in Fig. 1A) in Fig. 1B shows two test sites 140A, 140B each comprising a plurality of contact elements 142, for contacting to DUTs of the wafer 109. The gas distribution unit 130 and the test sites 140 are separated by the board 120. Further, the arrangement of the test sites 140A, 140B is also held and fixed by a probe head 150 at a centre of the probe board 120 (and the stiffener 110). The probe head 150 comprises the test sites 140A, 140B extending between the board 120 and the wafer 109. With a blurred line A a detail of the probe card 100 is indicated which is described in more detail with Fig. 2A and partially with Fig. 4.

**Fig. 1C** shows a bottom view of the probe card 100. In this perspective view of a bottom side, three functional parts of the probe card 100 are visible: The board 120 covers nearly the entire stiffener 110. Again, central to the board 120 (and the stiffener 110) there is the probe head 150 having a specific bottom surface 152. The plurality of contact elements 142 form the test sites 140A, 140B (see also Fig. 1B), and not depicted in Fig. 1C. However, the bottom surface 152 of the probe head 150 encloses the test sites 140 and the contact elements 142.

**Fig. 2A** shows detail A of the probe card as indicated with Fig. 1B. From top to bottom, Fig. 2A shows: The gas supply 230 feeds pressurized gas into the gas distribution unit 130 in which the pressurized gas is split into two paths of which the first branch 230A is led into the (left and) first test site 140A and the second branch 230B of pressurized gas is led into the (right and) second test site 140B. The process of properly splitting the pressurized gas into two branches by the gas distribution unit 130 will be described with Fig. 4. The first (and) left branch 230A of pressurized gas may pass a first (and left) through hole 225A of the board 120, and may flow into a central (and left) first gas supply channel 245A. From there the pressurized gas flows towards the wafer 109. With Fig. 2B the design of the test site 140A, 140B and the flow of the pressurized gas in a proximity of the wafer 109 will be described in more detail with detail B as indicated with a blurred line in Fig. 2A. In a similar way, the second (and right) branch 230B of pressurized gas may pass a second (and right) through hole 225B of the board 120, and may flow into a central (and right) second gas supply channel 245B before entering the right test site 140B and from there flowing to the wafer 109. The first test site 140A and the second test site 140B may be fixedly held inside probe head 150 and may be a part of the probe head 150.

In addition to Fig. 2A, in **Fig. 2B** a plurality of electronic components 209 of the wafer 109 are shown. The contact elements 142 (in this case formed as cantilever contact springs) of the test site 140A contact to an electronic component 209 being positioned directly central to and below the test site 140A. The bottom surface 152 of the probe head 150 extends in a rectangular shape as an elevated portion 255 around the central electronic component 209. While the elevated portion 255 faces towards the wafer 109 or electronic components 209, respectively, the elevated portion 255 forms a narrow venting slot 256 with the wafer 109 without touching the surface of the wafer 109, or without touching the electronic components 209, respectively. The main portion 253 of the bottom surface 152 of the probe head 150 is set back in comparison to the ring-like raised or elevated portion 255 of the bottom surface 152 of the probe head 150. As a consequence, the pressurized gas flows from the gas supply channel 245A of the test site 140A towards the central electronic component 209. From there, the pressurized gas is urged to pass the narrow venting slot 256 formed by the ring-like raised or elevated portion 255 and flows further outwards to the main portion 253 forming a wider venting slot 254 with the wafer 109. Hence, when the pressurized gas supplied by the gas supply 230 flows towards the elevated portion 255, the narrow venting slot 256 of the elevated portion 255 causes downstream a higher flow resistance on the gas flow 230 and thus there is a higher gas pressure around the group of contact elements 142. In addition, the ring-like elevated portion 255 directly surrounding the central electronic component (DUT) 209 may have a width so that the ring-like elevated portion 255 may face towards other electronic components 209 which are adjacent to the central electronic component (DUT) 209.

As an alternative, the probe head 150 may comprise a uniformly even bottom surface 152' as indicated with a blurred line. In this embodiment the flow resistance distributes evenly over a complete area of the bottom surface 152' of the probe head 150.

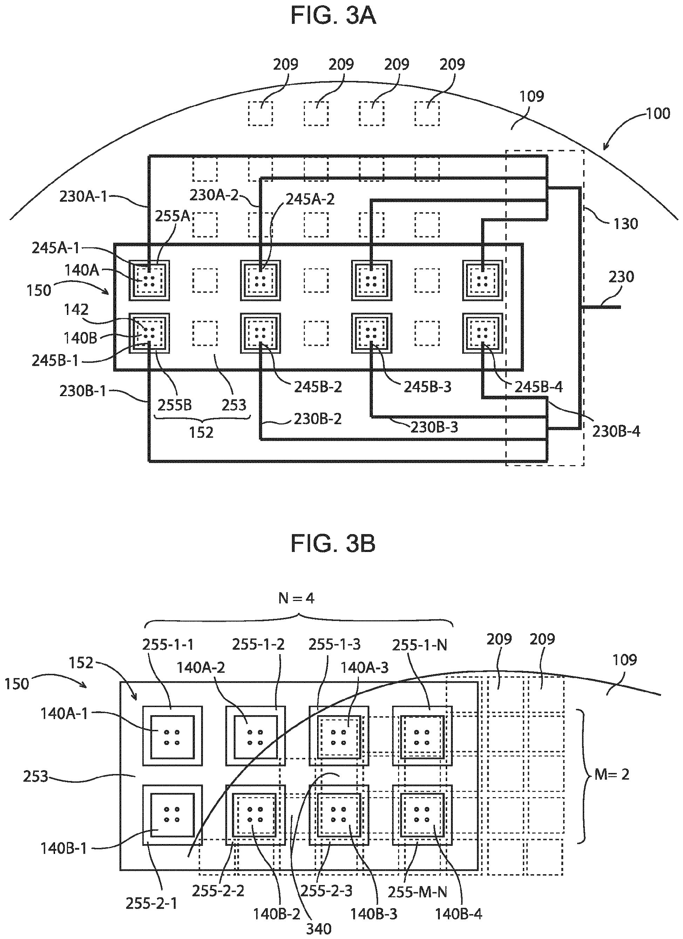

**Fig. 3A** shows a schematic illustration of a pressurized gas distribution of the probe card 100 when testing semiconductor components 209 of a wafer 109.

The pressurized gas is supplied by the gas supply 230 and distributed by the gas distribution unit 130 (depicted schematically) to an arrangement or matrix of contacted electronic components 209 by a plurality of branches 230A-1, 230B-1, 230A-2, 230B-2, 230B-3, 230B-4, wherein each electronic component 209 being contacted is supplied by one branch 230. The branches 230A-1, 230B-1, 230A-2, 230B-2, 230B-3, 230B-4 terminate towards the gas supply channels 245A-1, 245B-1, 245A-2, 245B-2, 245B-3, 245B-4. This means, that the gas distribution unit 130 distributes the pressurized gas into a plurality of branches 230A-1, 230B-1, 230A-2, 230B-2, 230B-3, 230B-4 which then end towards a plurality of gas supply channels 245A-1, 245B-1, 245A-2, 245B-2, 245B-3, 245B-4 supplying separately pressurized gas to a plurality of electronic components 209, respectively. Each test site 140A, 140B, etc. may comprise a group of contact elements 142 and may contact to a different one of the electronic components 209.

Moreover, in this embodiment, each contacted electronic component 209 (or DUT) is surrounded by one ring-like elevated portion 255A, 255B, etc. The pressure of the pressurized gas builds up for each of the contacted electronic components 209. The complete bottom surface 152 of the probe card (or the probe head 150, respectively,) may be formed by the plurality of ring-like, raised or elevated portions 255A, 255B, etc. and the main portion 253 which may be set back relative to the ring-like elevated portions 255A, 255B, etc. Fig. 3B shows a schematic illustration of the bottom surface 152 of the probe card 100 when semiconductor components 209 of a wafer 109 are tested, and when the probe card 100 is partially located next to the wafer 109. It is well known that wafers 109 are circular and that the electronic components 209 are arranged in regular lines and rows on the wafer 109. The test sites 140 and their contact elements 142 are in this case arranged in a MxN matrix of M lines and N rows for testing the electronic components. However, the test sites 140 may be arranged in any grid-like form or any grid-like manner, where each one of the test sites 140 faces one different electronic component 209. Fig. 3A shows the bottom surface 152 of the probe head150 wherein each test site 140A-1, 140B-1, etc. and the respective contact elements 142 are surrounded by one ring-like elevated portion 255-1-1, 255-2-1, 255-1-2, ..., 255-M-N, so that one ring-like elevated portion 255 corresponds to one electronic component (DUT) 209.

In addition, according to the embodiment shown with **Fig. 3B****,** the test sites 140 may be arranged so that one electronic component 209 is skipped in both directions of the main plain of the wafer, so that only every other electronic component 209 is tested in one specific row of electronic components 209. This may allow for the ring-like elevated portions 255 to overlap with electronic components 209 which are not tested. The omitted electronic components 209 which are not tested may be called "test gaps 340" on the test head 150 side.

In addition, the probe card 100 may reach the rounded end of the wafer 109, so that some of the test sites 140 (and in this case the test sites 140-1, 140-2, 140-3) are not located above the wafer 109. This means that these test sites 140-1, 140-2, 140-3 not only do not test electronic components 209 but also will lose the pressurized gas according to the then "open" branches 230A, 230B, 230C of pressurized gas.

**Fig. 4A** refers back to Fig. 2A and that the pressurized gas may be appropriately split into different branches, e.g. the first branch 230A and the second branch 230B which then feed the first gas supply channel 245A and the second gas supply channel 245B (see also Fig. 2A) through the first through hole 225A and the second through hole 225B of the board (PCB) 120, respectively. The gas distribution unit 130 may divide or split the pressurized gas from the gas supply 230 as follows: The gas distribution unit 130 may comprise a first distribution branch 230A, and a second distribution branch 230B both being connected to the gas supply 230 on one side and being connected to the first gas supply channel 245A and the second gas supply channel 245B through the first through hole 225A and the second through hole 225B, respectively, on the other side. Furthermore, in each of the first and the second branches 230A, 230B there may be fixtures to throttle the pressurized air. The first distribution branch 230A may comprise an electronically controlled first throttle valve 453A and the second distribution branch 230B may comprise an electronically controlled second throttle valve 453B. The first throttle valve 453A and the second throttle valve 453B may both be controlled by a control unit 455 which may allow for adjusting the flow through the first distribution branch 230A and the second distribution branch 230B. When one of the test sites 140A, 140B is not placed above the wafer 109 (compare Fig. 3B), e.g. the first test site 140A, and equivalent to this and the respective first branch 230A is free and loses pressurized gas, a respective first pressure sensor 455A in the first distribution branch 230A of the gas distribution unit 130 may sense the pressure decay. A connected control unit 455 may react and close the first throttle valve 453A. Since the same controlling of the gas flow may be achieved by a second pressure sensor 455B in the second distribution branch 230B of the gas distribution unit 130, a leakage for the pressurized gas may be avoided. However, in addition or as an alternative to this electronic control there may also be a first annular disc 451A placed in the first distribution branch 230A. A position of the first annular disc 451A may be adjusted by a first adjuster 452A (e.g. in the form of an adjusting screw) so that the first annular disc 451A may more or less throttle the gas flow through the first distribution branch 230A and thus limit a leakage, when the respective first branch 230A is free. The same may work with every test site 140 through which the gas flow is controlled and/or limited by a throttle valve 453B and/or an annular disc 451B, respectively. However, as a further alternative or in addition, the branches 230A, 230B and/or the gas distribution channels 245A, 245B may initially be designed to have a specific flow resistance and thus may limit gas loss when the respective test site 140A, 140B is not located above the wafer 109. Overall, this may help to avoid double testing.

**Fig. 4B** and **Fig. 4C** show bar charts of an effect of limiting the flow through "open" test sites by applying a higher flow resistance towards the test sites. The term "open test site" refers to a test site which is not located above the wafer. Both charts are normalized to 100% of the respective value (flow rate and pressure), when all test sites are located above the wafer and are contacting to the respective DUTs.

Fig. 4B shows a bar chart of a decay of the flow rate for a single test site when all test sites are closed 491, when 2 of 8 test sites are open 492, when 4 of 8 test sites are open 493, when 6 of 8 test sites are open 494, and when 7 of 8 test sites are open 495. In this configuration, when the flow resistance is chosen or adjusted appropriately, the loss of the flow rate for the only closed (495) test site, or contacting test site is just below 90% even if 7 of 8 test sites are open 495.

Fig. 4C shows a bar chart of a decay of the pressure for a single test site when all test sites are closed 491, when 2 of 8 test sites are open 492, when 4 of 8 test sites are open 493, when 6 of 8 test sites are open 494, and when 7 of 8 test sites are open 495. In this configuration, the loss of the pressure for the only closed test site 495, or contacting test site is more than 90%, compared to the pressure when all test sites are located above the wafer 491. Fig. 4B and Fig. 4C show an unexpected result that by adapting the flow resistance double testing may be avoided, while the pressure may have a value to allow for reducing arcing according to the Paschen's Law.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

### List of Reference Signs

| Fig. 1A | |
|---|---|
| 100 | probe card |
| 109 | wafer |
| 110 | stiffener |
| 120 | board |
| 130 | gas distribution unit |
| 230 | gas supply |
| | |

| Fig. 1B | |
|---|---|
| 140 | test site |
| 142 | contact elements (contact springs) |
| 150 | probe head |
| | A detail of the probe card |
| | |

| Fig. 1C | |
|---|---|
| 152 | bottom surface |
| | |

| Fig. 2A | |
|---|---|
| 130 | gas distribution unit |
| 140A | first test site |
| 140B | second test site |
| 225A | first through hole |
| 225B | second through hole |
| 230A | first branch (of pressurized gas) |
| 230B | second branch (of pressurized gas) |
| 245A | first gas supply channel |
| 245B | second gas supply channel |
| B | detail of gas supply to one test site |
| | |

| Fig. 2B | |
|---|---|
| 209 | DUTs |
| 245A | gas supply channel |
| 152 | bottom surface |
| 253 | main area |
| 254 | wide venting slot |
| 255 | elevated area |
| 256 | narrow venting slot |
| | |

| Fig. 3A | |
|---|---|
| 130 | gas distribution unit |
| | |

| Fig. 3B | |
|---|---|
| 255-1-1, ..., 255-1-N | elevated areas |
| 253 | main area |
| 340 | test gap |
| | |

| Fig. 4A | |
|---|---|
| 230 | pressurized gas |
| 230A | first branch |
| 451A | first annular disc |
| 452A | first adjuster |
| 453A | first throttle valve |
| 455A | first pressure sensor |
| 455 | control unit |
| 230B | second branch |
| 451B | second annular disc |
| 452B | second adjuster |
| 453B | second throttle valve |
| 455B | second pressure sensor |
| 455 | control unit |
| | |

| Fig. 4B | |
|---|---|
| 470 | normalized flow through one throttle valve |
| 491 | all test sites are closed |
| 492 | 2 of 8 test sites are open |
| 493 | 4 of 8 test sites are open |
| 494 | 6 of 8 test sites are open |
| 495 | 7 of 8 test sites are open |
| | |

| Fig. 4C | |
|---|---|
| 480 | normalized pressure at one throttle valve |

## Claims

1. A probe head (150) for parallel testing a plurality of electronic components (209) (DUTs) on a wafer (109), in particular for parallel testing high voltage semiconductor components, comprises:
- an arrangement of a plurality of test sites (140A-1, 140B-1, 140A-2, 140B-2, 140A-3, 140B-3), wherein each test site 140 is adapted to test a different electronic component (209),
- a plurality of groups of contact elements (142), wherein each group of contact elements (142) (of the plurality of group of contact elements (142) is assigned to a different one of the test sites (140A-1, 140B-1, 140A-2, 140B-2, 140A-3, 140B-3) and is adapted to contact to the respective electronic component 209, and wherein the probe head 150 further comprises
- a plurality of gas supply channels (245A-1, 245B-1, 245A-2, 245B-2, 245A-3, 245B-3), wherein each gas supply channel (245 passes through a different test site (140) of the plurality of test sites (140A-1, 140B-1, 140A-2, 140B-2, 140A-3), 140B-3 and supplies separately pressurized gas to the assigned group of contact elements (142).

2. The probe head (150) according to claim 1,
wherein the supply of separately pressurized gas through the gas supply channels (245A-1, 245B-1, 245A-2, 245B-2, 245A-3, 245B-3) is adaptable by a mechanical adjustment of a flow resistance for the plurality of the gas supply channels (245A-1, 245B-1, 245A-2, 245B-2, 245A-3, 245B-3).

3. The probe head (150) according to claim 1 or 2,
wherein a flow resistance for multiple of the gas supply channels (245A, 245B) is individually adjustable for each of the multiple gas supply channels (245A-1, 245B-1, 245A-2, 245B-2, 245A-3, 245B-3).

4. The probe head (150) according to any of the claims 1 to 3, further comprising
a plurality of electronically controllable throttle valves (453A, 453B),
wherein each one of the electronically controllable throttle valves (453A, 453B) is assigned to a different one of the gas supply channels (245A, 245B), and
wherein a flow resistance through each of the gas supply channels 245A, 245B) is electronically controlled by using the respective electronically controlled throttle valve (453A, 453B);
wherein in particular the flow resistance through each of the gas supply channels 245A, 245B) is increased as to switch off the flow completely by the assigned electronically controllable throttle valve (453A, 453B).

5. The probe head (150) according to any of the claims 1 to 4, further comprising
a gas supply (230),
wherein the gas supply (230) provides pressurized gas for each of the plurality of gas supply channels (245A-1, 245B-1, 245A-2, 245B-2, 245A-3, 245B-3).

6. The probe head (150) according to any of the claims 1 to 5,
wherein the separately pressurized gas is set to a pressure value preventing arcing between the contact elements (142) within each group of contact elements 142, between two neighbouring test sites (140A-1, 140B-1, 140A-2, 140B-2, 140A-3, 140B-3), or between neighbouring DUTs (209), according to Paschen's Law.

7. The probe head (150) according to any of the claims 2 to 6,
wherein arcing between a first number of contact elements (142), adapted to contact to the wafer (109), is prevented according to Paschen Law, in that a required gas pressure according to Paschen Law is fulfilled for the first number of contact elements (142), by in combination providing separately pressurized gas with a specific pressure value, and setting a specific value of the flow resistance through gas supply channels (245A, 245B) for a respective second number of contact elements (142) being adapted to be free of contacting to the wafer (109).

8. The probe head (150) according to any of the claims 1 to 7,
wherein the pressurized gas is pressurized air, and/or
wherein the arrangement of the test sites (140A-1, 140B-1, 140A-2, 140B-2, 140A-3, 140B-3) provides a plurality of test gaps 340 between the test sites (140A-1, 140B-1, 140A-2, 140B-2, 140A-3, 140B-3) in that the test sites (140) are adapted to test every other or less than every other of the electronic components (209) in one and/or the other direction of a main plane of the wafer (109).

9. The probe head (150) according to any of the claims 1 to 8, wherein the probe head (150) further comprises
- a bottom surface (152), wherein the bottom surface (152) comprises a main portion (253) and a plurality of elevated portions (255), wherein
- each one of the elevated portions (255) surrounds a different one of the groups of contact elements (142), and wherein the elevated portions (255) are raised relative to the main portion (253).

10. A probe card (100) comprising the probe head (150) according to any of the claims 1 to 9, and further comprising
a board (120) with a plurality of through holes (225A, 225B), and a gas distribution unit (230),
wherein the gas distribution unit (230) separates the gas supply (230) into different gas supply branches (230A and 230B) each entering a different one of the plurality of through holes (225A, 225B) and wherein each one of the plurality of through holes (225A, 225B) of the board (120) being arranged between the gas distribution unit (230) and the probe head 150 feeds a different one of the gas supply channels (245A, 245B) with separately pressurized gas, respectively.

11. A method of parallel testing a plurality of electronic components (209) on a wafer (109), in particular for parallel testing high voltage semiconductor components, comprises providing:
- an arrangement of a plurality of test sites (140A-1, 140B-1, 140A-2, 140B-2, 140A-3, 140B-3), wherein each test site (140) is adapted to test a different electronic component (209),
- a plurality of groups of contact elements (142), wherein each group of contact elements (142) (of the plurality of group of contact elements (142)) is assigned to a different one of the test sites (140A-1, 140B-1, 140A-2, 140B-2, 140A-3, 140B-3) and is adapted to contact to the respective electronic component (209), and wherein the probe head (150) further comprises
- a plurality of gas supply channels (245A-1, 245B-1, 245A-2, 245B-2, 245A-3, 245B-3), wherein each gas supply channel 245 passes through a different test site 140 of the plurality of test sites (140A-1, 140B-1, 140A-2, 140B-2, 140A-3, 140B-3) and supplies separately pressurized gas to the assigned group of contact elements (142),
wherein the method further comprises:
- parallel testing the plurality of electronic components (209) by contacting the assigned group of contact elements (142) to the plurality of electronic components (209) on the wafer (109), and
- supplying separately pressurized gas to the assigned group of contact elements (142) by the gas supply channels (245A-1, 245B-1, 245A-2, 245B-2, 245A-3, 245B-3).

12. The method according to claim 11,
wherein supplying of separately pressurized gas through the gas supply channels (245A-1, 245B-1, 245A-2, 245B-2, 245A-3, 245B-3) comprises:
- adapting a flow resistance for the plurality of the gas supply channels (245A-1, 245B-1, 245A-2, 245B-2, 245A-3, 245B-3) by a mechanical adjustment, and/or
wherein the method further comprising:
- adjusting a flow resistance for multiple of the gas supply channels (245A, 245B) individually for each of the multiple gas supply channels (245A-1, 245B-1, 245A-2, 245B-2, 245A-3, 245B-3)and/or wherein the method further comprises
providing a plurality of electronically controllable throttle valves (453A, 453B), wherein each one of the electronically controllable throttle valves (453A, 453B) is assigned to a different one of the gas supply channels (245A, 245B), and wherein the method further comprises:
- electronically controlling a flow resistance through each of the gas supply channels (245A, 245B) is by using the respective electronically controlled throttle valve (453A, 453B),
wherein the method in particular further comprises:
- increasing a flow resistance through each of the gas supply channels (245A, 245B) as to switch off the flow completely by the assigned electronically controllable throttle valve (453A, 453B).

13. The method according to claim 11 or 12, further comprising providing a gas supply (230), and wherein the method further comprises:
- providing pressurized gas for each of the plurality of gas supply channels (245A-1, 245B-1, 245A-2, 245B-2, 245A-3, 245B-3) by the gas supply (230).

14. The method according to any of the claims 11 to 13, wherein the method further comprises:
- setting the separately pressurized gas to a pressure value to prevent arcing between the contact elements (142) within each group of contact elements (142), between two neighbouring test sites (140A-1, 140B-1, 140A-2, 140B-2, 140A-3, 140B-3), or between neighbouring DUTs (209), according to Paschen's Law.

15. The method according to any of the claims 11to 14, wherein the method further comprises:
- preventing arcing between a first number of contact elements (142) according to Paschen Law, the first number of contact elements (142) contacting to the wafer (109), by providing a required gas pressure according to Paschen Law for the first number of contact elements (142), in that in combination
- providing separately pressurized gas with a specific pressure value to the first number of contact elements (142), and
- setting a specific value of the flow resistance through gas supply channels (245A, 245B) for a respective second number of contact elements (142), the second number of contact elements (142) not contacting to the wafer (109).
